# FASCICULE DE BREVET EUROPEEN

(11) **EP 2 491 576 B1**
(45) Date de publication et mention de la délivrance du brevet: **02.04.2014**
(21) Numéro de dépôt: 10785124.8
(22) Date de dépôt: 15.10.2010
(51) Int. Cl.: H01L 21/762, H01L 21/02

(54) **PROCEDE DE FABRICATION D'UN FILM MULTICOUCHE COMPRENANT AU MOINS UNE COUCHE MINCE DE SILICIUM CRISTALLIN**
VERFAHREN ZUR HERSTELLUNG EINES MEHRSCHICHTIGEN FILMS MIT MINDESTENS EINER DÜNNEN SCHICHT AUS KRISTALLINEM SILIZIUM
METHOD FOR PRODUCING A MULTILAYER FILM INCLUDING AT LEAST ONE THIN LAYER OF CRYSTALLINE SILICON

(30) Priorité: 19.10.2009 FR 0957301
(43) Date de publication de la demande: 29.08.2012
(73) Titulaire: Ecole Polytechnique, 91120 Palaiseau Cédex (FR); Centre National de la Recherche Scientifique, 75016 Paris Cedex 16 (FR)
(72) Inventeur: ROCA I CABARROCAS, Pere, F-91140 Villebon Sur Yvette (FR); MORENO, Mario, F-91120 Palaiseau (FR)
(74) Mandataire: Coralis Harle
(86) Numéro de dépôt international: PCT/FR2010/052198
(87) Numéro de publication internationale: WO 2011/048308

(56) Documents cités:
- EP-A1- 1 445 802
- US-A1- 2008 188 062
- US-A1- 2008 245 414
- ROCA I CABARROCAS: "New approaches for the production of nano-, micro-, and polycrystalline silicon thin films", PHYSICA STATUS SOLIDI (C), WILEY - VCH VERLAG, BERLIN, DE, vol. 1, no. 5, 1 janvier 2004 (2004-01-01) , pages 1115-1130, XP009133576, ISSN: 1610-1634
- BERGMANN R B ET AL: "The future of crystalline silicon films on foreign substrates", THIN SOLID FILMS, ELSEVIER-SEQUOIA S.A. LAUSANNE, CH, vol. 403-404, 1 janvier 2002 (2002-01-01), pages 162-169, XP002566392, ISSN: 0040-6090
- ROCA I CABARROCAS P ET AL: "MICROCRYSTALLINE SILICON: AN EMERGING MATERIAL FOR STABLE THIN-FILM TRANSISTORS", JOURNAL OF THE SOCIETY FOR INFORMATION DISPLAY - SID, SOCIETY FOR INFORMATION DISPLAY LNKD- DOI:10.1889/1.1824232, vol. 12, no. 1, 1 mars 2004 (2004-03-01), pages 3-09, XP008058508, ISSN: 1071-0922
- "Effect of hydrogen plasma precleaning on the removal of interfacial amorphous layer in the chemical vapor deposition of microcrystalline silicon films on silicon oxide surface", APPLIED PHYSICS LETTERS, AIP, AMERICAN INSTITUTE OF PHYSICS, MELVILLE, NY, US LNKD- DOI:10.1063/1.115864, vol. 68, no. 16, 15 avril 1996 (1996-04-15), pages 2219-2221, XP012015051, ISSN: 0003-6951

## Description

L'invention concerne un procédé de fabrication d'un film multicouche comprenant une ou plusieurs couches minces de silicium cristallin, à partir d'un substrat ayant une structure cristalline.

Ce film multicouche, à base de silicium cristallin (c-Si), est destiné à être déposé sur un support flexible ou rigide pour fabriquer des cellules solaires ou des dispositifs microélectroniques.

On entend par couche mince, une couche ayant une épaisseur comprise entre 0,1 µm et 5 µm.

Les cellules solaires ayant un rendement élevé et les dispositifs microélectroniques sont fabriquées en silicium cristallin.

Le problème avec les cellules solaires et les dispositifs microélectroniques à base de silicium cristallin est que leur coût de fabrication est élevé à cause des grandes quantités de silicium utilisées pour leur fabrication.

Il existe des méthodes qui visent à réduire les quantités de silicium cristallin nécessaires pour la fabrication des cellules solaires et des dispositifs microélectroniques.

Plus particulièrement, ces méthodes permettent d'obtenir des cellules solaires à hétérojonction fabriquées sur des substrats de silicium cristallin minces (50 µm à 100 µm) fournissant des rendements très élevés (17 % à 22 %).

On connaît également des méthodes de fabrication d'une couche de silicium cristallin utilisant un plasma SiF₄ /Ar/ hydrogène, voir phys. stat. sol (c) 1, No. 5, 1115-1130.

Il existe d'autres procédés comme le procédé de découpage à implantation d'ions H⁺ (« smart cut »), et le procédé de découpage ionique qui permettent d'obtenir des films de silicium cristallin ayant des épaisseurs réduites.

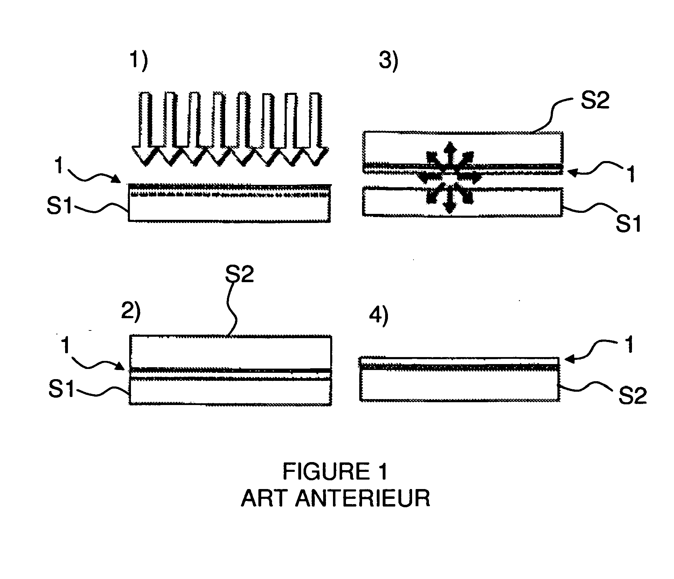

Le procédé de découpage (« smart cut »), illustré sur la figure 1, est connu du document « M. Bruel, Separation of silicon wafers by the smart cut method, Mat. Res. Innovat. (1999) 3, 9 - 13 ».

Ces techniques utilisent l'implantation d'ions H⁺ sur des substrats de silicium cristallin à des doses comprises entre 10¹⁶ et 10¹⁷ H⁺/cm², afin de créer des défauts (microcavités) à une certaine distance de la surface du substrat de silicium.

On obtient un substrat comprenant une couche de silicium cristallin très mince (0,3 µm à 1 µm) et fortement défectueuse.

Ensuite, une liaison hydrophile est réalisée avec un deuxième substrat de silicium cristallin. Le deuxième substrat de silicium cristallin est mis en contact avec la surface défectueuse du premier substrat. Un traitement thermique est réalisé à une température supérieure à 1000°C.

Pendant la première phase du traitement, le film de silicium cristallin très mince se sépare du premier substrat, et se solidarise du deuxième substrat. Lors d'une deuxième phase, les liaisons chimiques entre le film de silicium cristallin très mince et le deuxième substrat sont consolidées.

L'inconvénient de ces processus est qu'ils font intervenir des étapes d'implantation d'ions H⁺, et de traitement thermique à haute température (>1000°C) qui sont des étapes compliquées à mettre en oeuvre et coûteuses. Le recuit à haute température limite aussi les procédés aux substrats de silicium cristallin ou matériaux réfractaires.

De plus, avec ces procédés de l'art antérieur, il n'est pas possible d'obtenir des épaisseurs de film de silicium cristallin inférieures à 0,3 µm ou supérieures à 1 µm, ni de réaliser directement des jonctions ou dispositifs.

Ainsi, l'invention a pour objet de proposer un procédé de fabrication d'une multicouche comprenant au moins une couche mince de silicium cristallin plus simple, moins onéreux et permettant d'obtenir des films de silicium cristallin ayant une épaisseur variable entre 0,1 µm et 5 µm.

A cet effet, l'invention concerne un procédé de fabrication d'un film multicouche comprenant au moins une couche mince de silicium cristallin, à partir d'un substrat ayant une structure cristalline et comprenant une surface préalablement nettoyée.

Selon l'invention, le procédé comprend les étapes suivantes :
a) exposition de ladite surface nettoyée à un plasma radiofréquence généré dans un mélange gazeux de SiF₄, d'hydrogène et d'argon, la densité de puissance du plasma radiofréquence étant comprise entre 100 mW/cm² et 650 mW/cm², la pression du mélange gazeux étant comprise entre 200 Pa et 400 Pa, la température du substrat étant comprise entre 150°C et 300°C, le flux de SiF₄ étant compris entre 1 et 10 cm³/min, le flux d'hydrogène étant compris entre 1 et 60 cm³/min et le flux d'argon étant compris entre 1 et 80 cm³/min, afin de former sur ladite surface nettoyée, une couche mince de silicium cristallin comportant plusieurs sous couches dont une sous couche d'interface en contact avec le substrat et comprenant des microcavités,
b) dépôt d'au moins une couche de matériau sur ladite couche mince de silicium cristallin pour former, avec ladite couche mince de silicium cristallin, un film multicouche, ledit film multicouche comprenant au moins une couche mécaniquement résistante pour former un film multicouche ayant une résistance suffisante pour permettre le décollement dudit film multicouche sans endommager la couche mince de silicium cristallin,
c) recuit du substrat recouvert dudit film multicouche, à une température supérieure à 400°C, permettant la séparation dudit film multicouche du substrat.

On obtient ainsi un film multicouche autosupporté. Le film multicouche peut être ensuite transféré sur un support mécanique souple ou rigide, non cristallin, et le substrat cristallin peut être réutilisé.

Dans différents modes de réalisation possibles, la présente invention concerne également les caractéristiques suivantes qui pourront être considérées isolément ou selon toutes leurs combinaisons techniquement possibles et apportent chacune des avantages spécifiques :
- la durée de l'étape a) est comprise entre 1 min et 5 heures,
- lors de l'étape a), la densité de puissance du plasma radiofréquence est de 500 mW/cm², la pression du mélange gazeux est de 293 Pa, et la température du substrat est de 200°C,
- lors de l'étape a), le débit gazeux de SiF₄ est de 3 cm³/min, le débit gazeux d'hydrogène est de 5 cm³/min, et le débit gazeux d'argon est de 80 cm³/min,
- la couche mécaniquement résistante est une couche de chrome déposée sur une des couches du film multicouche mécaniquement résistant par une méthode d'évaporation sous vide,
- lors de l'étape c), le substrat recouvert dudit film multicouche mécaniquement résistant est chauffé jusqu'à 800°C,
- lors de l'étape b), ladite couche de chrome est recouverte d'une couche de polyamide, lors de l'étape c), le substrat recouvert de la multicouche étant chauffé jusqu'à une température comprise entre 300°C et 500°C,
- la surface du substrat étant initialement recouverte d'une couche d'oxyde de silicium, le procédé de fabrication comprend, avant l'étape a), une étape a') de nettoyage de la surface du substrat initialement recouverte d'oxyde de silicium,
- ladite étape a') comprend une opération d'exposition de ladite surface à un plasma radiofréquence généré à partir d'un gaz fluoré, produisant le décapage de la couche d'oxyde de silicium, et une opération d'exposition de ladite surface à un plasma radiofréquence d'hydrogène,
- les étapes a') et a) sont réalisées dans une même chambre de réaction d'un réacteur de dépôt chimique en phase vapeur assisté par plasma.
- l'étape a') comprend une opération standard de nettoyage par voie humide à base d'eau déionisée et HF,
- l'étape b) comprend une opération de dépôt d'une couche de passivation (nitrure ou oxyde de silicium) avant le dépôt de la couche mécaniquement résistante,
- lors de l'étape b), le matériau déposé est du silicium ou du germanium cristallin, intrinsèque ou dopé,
- lors de l'étape b), une première couche de matériau dopé P ou N est déposée
sur ladite couche mince de silicium cristallin, ladite première couche de matériau dopé P ou N étant recouverte d'une deuxième couche de matériau dopé N ou P afin d'obtenir une jonction P-N ou N-P.

Ainsi, l'invention fournit un procédé de fabrication de films multicouches plus simple, moins onéreux, plus flexible et permettant d'obtenir des films de silicium cristallin ayant une épaisseur comprise entre 0,1 µm et 5 pm et de grande cristallinité.

L'utilisation d'un procédé de découpage par implantation d'ions H⁺, qui est compliqué à mettre en oeuvre et coûteux n'est plus nécessaire. Le procédé de l'invention est une alternative à ce procédé de découpage.

Le procédé de l'invention est en partie mis en oeuvre dans un réacteur PECVD contrairement aux procédés de l'art antérieur (« smart cut », par exemple), ce qui permet de déposer la couche mince de silicium cristallin à basse température. Le substrat n'est pas consommé.

De plus, contrairement aux procédés de l'art antérieur, l'invention permet d'utiliser des températures de recuit plus faibles (~ 400 °C - 600 °C) contre environ 1000°C pour les procédés de l'art antérieur.

L'invention permet également de réaliser des empilements de couches dopées et non dopées pour former des jonctions P-N ou N-P. Dans les procédés de l'art antérieur, le dopage est fixé par le substrat, ce qui est contraignant.

Selon l'invention, il est également possible d'incorporer d'autres éléments comme le germanium et donc de réaliser des multicouches Si/Ge, par exemple. Avec le procédé (« smart cut ») de l'art antérieur, il n'est pas possible de déposer des matériaux autres que celui du substrat.

L'invention sera décrite plus en détail en référence aux dessins annexés dans lesquels :
- la figure 1 représente un procédé de découpage par implantation ionique de l'art antérieur ;
- la figure 2 représente un procédé de fabrication d'un film multicouche comprenant une couche mince de silicium cristallin, selon un premier mode de réalisation de l'invention ;
- la figure 3 représente un procédé de fabrication d'une multicouche comprenant une couche mince de silicium cristallin, selon un deuxième mode de réalisation de l'invention ;
- la figure 4a représente un graphique dans lequel est représenté la vitesse de dépôt de la sous couche épitaxiale fine de coeur de la couche mince de silicium et la composition de cette dernière en fonction du débit d'hydrogène ;
- la figure 4b représente un graphique dans lequel est représenté l'épaisseur de la sous couche d'interface et la composition de cette dernière en fonction du débit d'hydrogène ;
- la figure 4c représente un graphique dans lequel est représenté la rugosité de la sous couche de surface et la composition de cette dernière en fonction du débit d'hydrogène ;
- la figure 5 représente le détail de la couche mince de silicium cristallin.

La figure 1 représente un procédé de découpage par implantation ionique de l'art antérieur.

Ce procédé comprend une première étape 1) d'implantation d'ions H⁺ sur un premier substrat de silicium cristallin S1, recouvert d'une couche mince d'oxyde de silicium, à des doses comprises entre 10¹⁶ et 10¹⁷ H⁺/cm², afin de créer des défauts (microcavités) à une certaine distance de la surface du substrat de silicium.

On obtient un substrat comprenant une couche de silicium cristallin 1 très mince (0,3 à 1 µm) et fortement défectueuse.

Ensuite, il est prévu une deuxième étape 2) consistant à nettoyer le premier substrat de silicium cristallin S1 et un deuxième substrat de silicium cristallin S2, et à réaliser des liaisons hydrophiles avec ce deuxième substrat de silicium cristallin S2, à température ambiante. Le deuxième substrat de silicium cristallin S2 est mis en contact avec la surface défectueuse du premier substrat S1.

Une troisième étape 3) de traitement thermique est réalisée à une température supérieure à 1000°C. Pendant une première phase du traitement thermique (400°C-600°C), le film de silicium cristallin très mince 1 se sépare du premier substrat S1, tout en restant solidaire du deuxième substrat S2. Lors d'une deuxième phase de traitement thermique (T>1000°C), les liaisons chimiques entre le film de silicium cristallin très mince 1 et le deuxième substrat S2 sont consolidées.

Une quatrième étape 4) consiste à polir la surface du film de silicium cristallin très mince 1 du deuxième substrat S2.

L'inconvénient de ce processus est qu'il fait intervenir des étapes d'implantation d'ions H⁺, et de traitement thermique à haute température (>1000°C) qui sont des étapes compliquées à mettre en oeuvre et coûteuses.

De plus, avec ce procédé de l'art antérieur, il n'est pas possible d'obtenir des épaisseurs de film de silicium cristallin inférieures à 0,3 µm, ni supérieures à 1 µm.

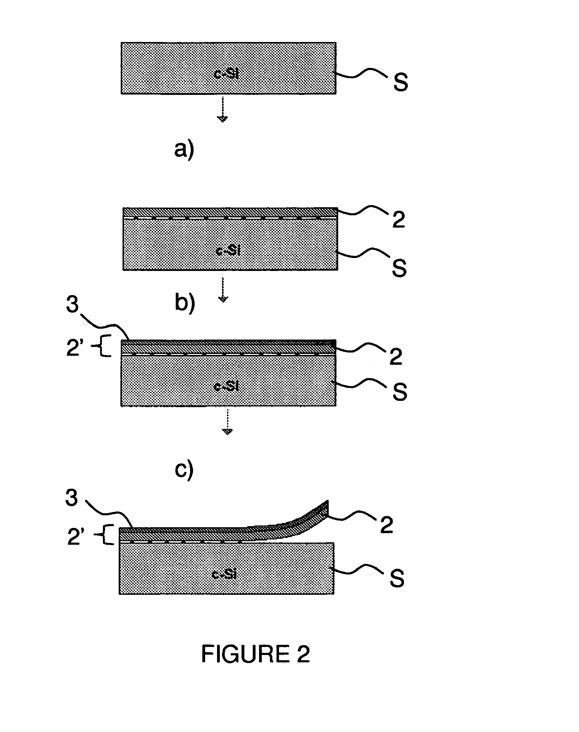

La figure 2 représente un procédé de fabrication d'un film multicouche 2' comprenant une couche mince de silicium cristallin 2 à partir d'un substrat S ayant une structure cristalline, selon un premier mode de réalisation de l'invention.

Le substrat S comprend une surface préalablement nettoyée, c'est-à-dire sans oxyde. Le procédé de nettoyage est décrit plus loin.

Le substrat S peut être un substrat de silicium cristallin ou de germanium cristallin, par exemple.

Le substrat S peut être un substrat <100> FZ, CZ, ou autre. Il peut être poli sur ses deux faces, par exemple. Il peut avoir une résistivité quelconque. Dans les exemples ci-dessous, il présente une résistivité comprise entre 1 et 5 Ωcm.

Le procédé de l'invention peut être appliqué sur une ou les deux faces opposées du substrat de silicium.

Dans les exemples ci-dessous, le substrat S est un substrat de silicium cristallin.

Le procédé de fabrication du film multicouche 2' comprend une étape a) d'exposition de la surface nettoyée du substrat S à un plasma radiofréquence généré dans un mélange gazeux comprenant du SiF₄, de l'hydrogène et de l'argon, pour former, sur la surface du substrat S, une couche mince de silicium cristallin 2 comprenant des microcavités. Ces microcavités comprennent de l'hydrogène.

La puissance du plasma radiofréquence est comprise entre 10 W (densité de puissance de 100 mW/cm²) et 60 W (densité de puissance de 600 mW/cm²). La pression du mélange gazeux est comprise entre 200 Pa et 400 Pa.

La température du substrat est comprise entre 150°C et 300°C, le flux de SiF₄ est compris entre 1 et 10 cm³/min, le flux d'hydrogène est compris entre 1 et 60 cm³/min et le flux d'argon est compris entre 1 et 80 cm³/min.

La durée de l'étape a) est de préférence comprise entre 1 min et 5 heures. Elle peut également être inférieure ou supérieure. Par exemple, lorsque l'étape a) est réalisée pendant 10 min, on obtient une couche mince de silicium cristallin 2 ayant une épaisseur de 0,15 µm.

L'épaisseur de la couche mince de silicium cristallin 2 dépend de la durée de l'étape a) et du débit de SiF₄.

Par exemple, pour une vitesse de dépôt d'environ 0,3 nm/s, une durée de 10 min pour l'étape a) peut correspondre à une épaisseur de couche mince de silicium cristallin 2 de 0,18 µm. Une durée de 5 heures pour l'étape a) peut correspondre à une épaisseur de couche mince de silicium cristallin de 5,4 µm.

De manière préférée, lors de l'étape a), la puissance du plasma radiofréquence est de 50 W (densité de puissance de 500 mW/cm²), la pression du mélange gazeux est de 293 Pa, la durée de l'exposition au plasma radiofréquence est de 30 min (pour déposer une couche mince de silicium cristallin 2 d'une épaisseur de 0,5 µm), et la température du substrat S est de 200°C.

De manière encore plus préférée, le débit gazeux de SiF₄ est fixé à 3 cm³/min, le débit gazeux d'hydrogène est compris entre 1 et 60 cm³/min, et le débit gazeux d'argon est de 80 cm³/min.

De manière encore plus préférée, le débit gazeux de SiF₄ est fixé à 3 cm³/min, le débit gazeux d'hydrogène est fixé à 5 cm³/min, et le débit gazeux d'argon est de 80 cm³/min. On obtient un rapport H₂/SiF₄ de 1,66.

Après cette étape a) d'exposition d'une surface du substrat S à un plasma radiofréquence de H₂/SiF₄/Ar réalisée pendant 30 min dans les conditions optimales ci-dessus, on obtient une couche mince de silicium cristallin 2 composé de trois sous couches dont une sous couche d'interface 19, une sous couche épitaxiale de coeur 20, et une sous couche de surface 21.

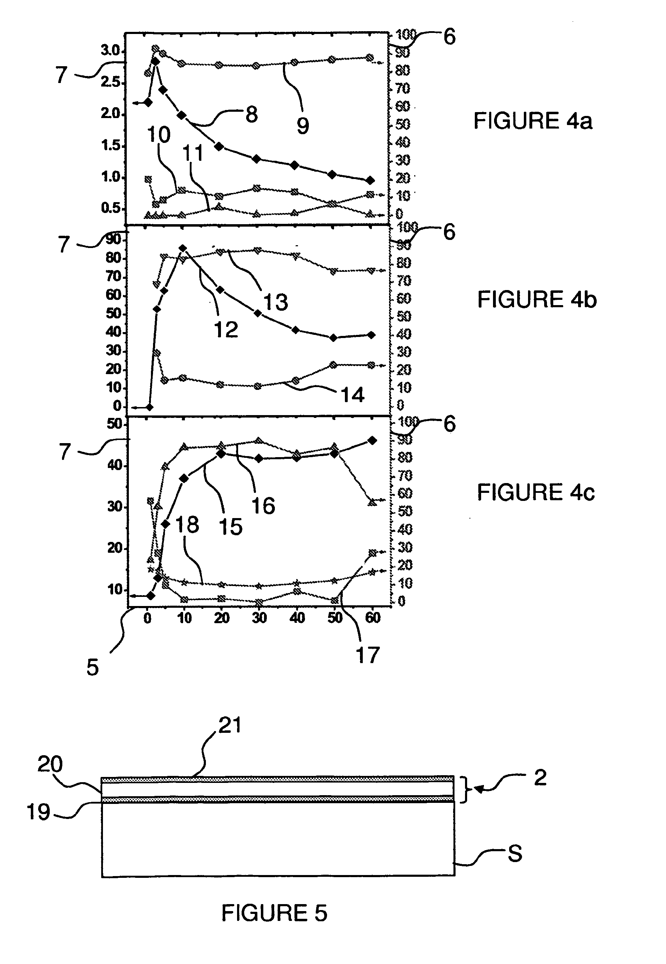

Le détail de la couche mince de silicium cristallin 2 est représenté sur la figure 5.

La sous couche d'interface 19 comprend une grande fraction de microcavités et une petite fraction de silicium cristallin. Cette sous couche d'interface 19 est directement en contact avec la surface du substrat. Elle est positionnée entre le substrat S et la sous couche épitaxiale de coeur 20. Elle présente une épaisseur comprise entre 0 et 9 nm, qui dépend de la fraction d'hydrogène utilisée.

La sous couche épitaxiale de coeur 20 est composée d'une fraction de silicium monocristallin, d'une fraction de gros grains de silicium cristallin et d'une fraction de petits grains de silicium cristallin. La sous couche épitaxiale de coeur 20 présente une épaisseur comprise entre 90 nm et 170 nm (pour 10 min de plasma).

La sous couche de surface 21 est composée d'une fraction de gros grains de silicium cristallin, d'une fraction de petits grains de silicium cristallin, et d'une fraction de SiO₂. Elle présente une épaisseur comprise entre 0 et 5 nm.

L'épaisseur de toutes ces sous couches dépendent de la fraction d'hydrogène utilisée pour la dilution du SiF₄.

La figure 4a représente la vitesse de dépôt de la sous couche épitaxiale fine de coeur 20 de la couche mince de silicium 2 et la composition de cette dernière en fonction du débit d'hydrogène (débits entre 1 et 60 cm³/s).

Le débit de SiF₄ est de 3 cm³/s et le débit d'Ar est de 80 cm³/s pour les exemples des figures 4a à 4c.

Les abscisses 5 représentent le débit d'hydrogène (cm³/s). Dans la figure 4a les ordonnées 7 (à gauche) représentent la vitesse de dépôt de la sous couche épitaxiale de coeur 20, et les ordonnées 6 (à droite) représentent la composition (en %) de cette dernière.

La courbe 8 représentant la vitesse de dépôt de la sous couche épitaxiale de coeur 20 en fonction du débit d'hydrogène montre qu'à basse dilution d'H₂, la vitesse de dépôt est basse, comprise entre 0,1 nm/s et 0,3 nm/s.

Cependant, quand la dilution d'H₂ augmente, la vitesse de dépôt augmentent également, avec un maximum de près de 0,3 nm/s (quand le débit de SiF₄ = le débit de H₂ = 3 cm³/s).

Un accroissement ultérieur de la dilution d'H₂ a comme conséquence un taux de dépôt inférieur.

La courbe 9 représente la fraction de silicium monocristallin (c-Si) en fonction du débit d'hydrogène.

La courbe 10 représente la fraction de petits grains de silicium en fonction du débit d'hydrogène.

La courbe 11 représente la fraction de gros grains de silicium en fonction du débit d'hydrogène.

Les courbes 9 à 11 montrent que la sous couche épitaxiale de coeur 20 a une haute fraction de silicium cristallin (environ 80 % à 95 %), une fraction de petits grains de silicium d'environ 5 % à 20 %, et une fraction de gros grains d'environ 1 % à 5%. La fraction de silicium cristallin la plus haute (~ 95 %) a été obtenue pour un film de silicium cristallin 2 déposé avec des débits de SiF₄ et H₂ identiques (3 cm³/min), et un débit d'argon de 80 cm³/min.

La figure 4b représente l'épaisseur de la sous couche d'interface 19 et la composition de cette dernière en fonction du débit d'hydrogène (débits entre 1 et 60 cm³/min).

La courbe 12 représente l'épaisseur de la sous couche d'interface 19 en fonction du débit d'hydrogène.

La courbe 13 représente la fraction de microcavités en fonction du débit d'hydrogène.

La courbe 14 représente la fraction de silicium cristallin en fonction du débit d'hydrogène.

Pour un bas débit d'H₂ (1 cm³/min), il n'y a pas de sous couche d'interface 19 du tout. Quand le débit d'H₂ augmente, la sous couche d'interface 19 apparaît et atteint un maximum d'épaisseur pour 10 cm³/min. Un accroissement du débit d'H₂ entraîne une diminution de l'épaisseur de la sous couche d'interface 19. La raison d'un tel comportement est qu'à un bas débit d'H₂, la vitesse de dépôt est basse et donc l'hydrogène peut être désorbé du film mince de silicium 2 qui se développe.

Quand le débit d'H₂ est plus haut, la vitesse de dépôt augmente, et l'hydrogène est emprisonné dans l'interface avec le substrat de silicium cristallin. A un débit d'H₂ encore plus élevé, la vitesse de dépôt diminue encore. Une certaine quantité d'hydrogène est emprisonnée dans la sous couche d'interface 19 et une autre partie est désorbée, ayant pour résultat une diminution de l'épaisseur de la couche d'interface.

Les courbes 13 et 14 montrent que la sous couche d'interface 19 se compose principalement de microcavités (environ 80%) et d'un peu de silicium cristallin (environ 20 %). La composition est presque indépendante de la dilution d'H₂.

La figure 4c représente la rugosité de la sous couche de surface 21 et la composition de cette dernière en fonction du débit d'hydrogène (débits entre 1 et 60 cm³/min).

La courbe 15 représente la rugosité de la sous couche de surface 21 en fonction du débit d'hydrogène.

La courbe 16 représente la fraction des gros grains de silicium en fonction du débit d'hydrogène.

La courbe 17 représente la fraction des petits grains de silicium en fonction du débit d'hydrogène.

La courbe 18 représente la fraction de SiO₂ en fonction du débit d'hydrogène.

La courbe 15 montre que la rugosité des couches minces de silicium 2 augmente avec le débit d'H₂, d'environ 0,9 nm pour un débit de 1 cm³/min, jusqu'à environ 4,5 nm pour un débit de 60 cm³/min.

D'après les courbes 17 à 18, la fraction de SiO₂ est presque indépendante du débit d'hydrogène.

La sous couche d'interface 19 présente des quantités d'oxygène, d'hydrogène et de fluor plus importantes que la sous couche épitaxiale de coeur 20. Ceci est du au fait que la sous couche d'interface 19 présente beaucoup de défauts (environ 80% de microcavités).

Le procédé de fabrication d'un film multicouche 2' comprend également une étape b) de dépôt d'au moins une couche de matériau sur la couche mince de silicium cristallin 2 pour former, avec la couche mince de silicium cristallin 2, un film multicouche 2'. Le film multicouche 2' comprend au moins une couche mécaniquement résistante 3 pour former un film multicouche 2' mécaniquement résistant et mécaniquement stable.

La couche mécaniquement résistante 3 est la dernière couche qui est déposée sur le film multicouche 2'.

La couche mécaniquement résistante 3 est préférentiellement une couche métallique. Elle peut être d'un autre matériau comme le verre ou en polymère. On entend par « film multicouche 2' mécaniquement résistant », un film multicouche 2' ayant une résistance suffisante pour permettre le décollement de la multicouche, lors d'une étape ultérieure décrite ci-dessous, sans endommager la couche mince de silicium cristallin 2.

La couche mécaniquement résistante 3 est préférentiellement en chrome. Elle est déposée sur une des couches du film multicouche 2' par une méthode d'évaporation sous vide. L'épaisseur de la couche de chrome 3 est supérieure à 100 nm. Une épaisseur de chrome de 150 nm assure une résistance mécanique suffisante au film multicouche 2' pour permettre son décollement ultérieur du substrat S.

Selon le mode de réalisation de la figure 2, lors de l'étape b), seule une couche de chrome est déposée sur la couche mince de silicium cristallin 2.

Selon un autre mode de réalisation possible, lors de l'étape b) de dépôt, une ou plusieurs couches épitaxiales de matériaux semi-conducteurs sont déposées sur la couche mince de silicium cristallin 2, pour former un film multicouche 2' comprenant une ou plusieurs couches de matériaux semi-conducteurs entre la couche mince de silicium cristallin 2 et la couche mécaniquement résistante 3.

Ces couches de matériaux semi-conducteurs peuvent être à base de silicium, de germanium ou de SiGe, par exemple. Elles peuvent être intrinsèques, dopées p ou dopées n. Le film multicouche 2' peut former une jonction PIN ou NIP, P-N ou N-P. Il est possible de former des jonctions directement sur le substrat S.

Selon un mode de réalisation possible, l'étape b) comprend une opération de dépôt d'une couche de passivation avant le dépôt de la couche mécaniquement résistante 3. Cette couche de passivation peut être une couche de nitrure de silicium permettant d'obtenir une faible densité de défauts de surface.

Le procédé de fabrication d'un film multicouche 2' comprend également une étape c) de recuit du substrat S recouvert de la multicouche à une température supérieure à 400°C et de préférence comprise entre 400°C et 900°C, permettant la séparation ou le décollage du film multicouche 2' et par conséquent de la couche mince de silicium cristallin 2, du substrat S.

Pendant l'étape c), lors de la montée en température, les atomes d'hydrogène se recombinent dans les microcavités de la couche mince de silicium cristallin 2 pour former des micro bulles d'H₂, générant une augmentation de volume des microcavités dans la couche mince de silicium cristallin 2.

Selon le mode de réalisation de la figure 2, lors de l'étape c), le substrat S recouvert de la multicouche est chauffé jusqu'à 800°C dans un four.

La température du four est ensuite abaissée jusqu'à la température ambiante.

Eventuellement, le four peut être ouvert à environ 250°C pour améliorer le décollement du film multicouche 2' de la surface du substrat S.

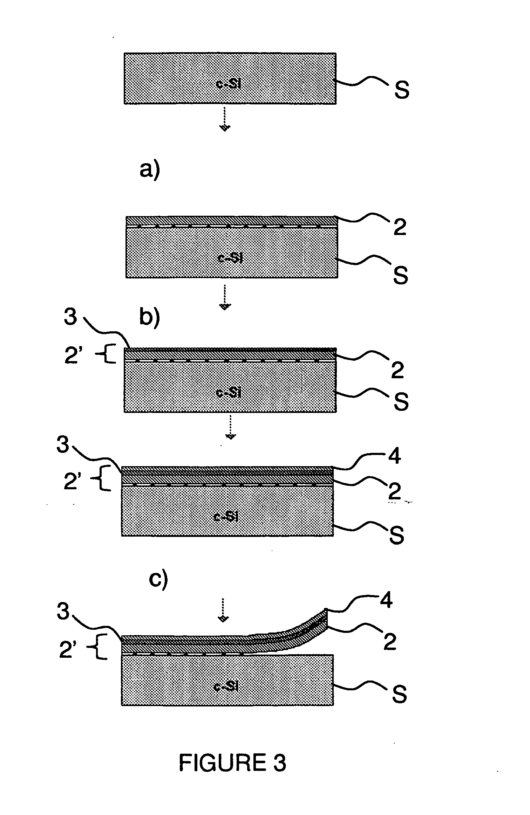

Selon un autre mode de réalisation, illustré sur la figure 3, lors de l'étape b), la couche de chrome 3 est ensuite recouverte d'une couche de polyamide 4. Le substrat S recouvert du film multicouche 2' est ensuite chauffé dans un four à 250°C - 350 °C.

Ensuite, lors de l'étape c), le substrat S recouvert du film multicouche 2' est chauffé jusqu'à 300°C - 500°C dans ce four.

La température du four est ensuite abaissée jusqu'à la température ambiante.

Eventuellement, le four peut être ouvert à environ 250°C pour améliorer le décollement du film multicouche 2' de la surface du substrat S.

De façon alternative, l'étape c) de recuit peut être réalisée dans un four à recuit thermique rapide RTA ("Rapid Thermal Annealing") comprenant des lampes chauffantes permettant de réaliser une montée en température très rapide. Il est possible d'atteindre 900 °C en quelques minutes.

Le procédé de fabrication d'un film multicouche 2' peut comprendre, avant l'étape a), une étape a') de nettoyage de la surface du substrat initialement recouverte d'oxyde de silicium (SiO₂), telle que décrite dans le document FR 0 955 766.

Selon un mode de réalisation possible, cette étape a') comprend une opération d'exposition de la surface à un plasma radiofréquence généré à partir d'un gaz fluoré, produisant le décapage de la couche d'oxyde de silicium, et une opération d'exposition de la surface à un plasma radiofréquence d'hydrogène.

Le gaz fluoré (ou à base de fluor) est préférentiellement un gaz de SiF₄. D'autres gaz fluorés peuvent être utilisés, comme le SF₆, par exemple.

Selon un autre mode de réalisation possible, l'étape a') de nettoyage peut être réalisée par voie humide avec une solution standard d'acide fluorhydrique diluée avec de l'eau déionisée.

L'avantage de l'utilisation du procédé par plasma RF est que les étapes a'), et a) peuvent être réalisées dans une même chambre de réaction d'un réacteur de dépôt chimique en phase vapeur assisté par plasma (PECVD), fonctionnant à une fréquence de 13,56 MHz.

Ainsi, le procédé de l'invention peut être mis en oeuvre dans une chambre de dépôt chimique en phase vapeur assisté par plasma (PECVD) unique. Les étapes a') et a) sont réalisées dans cette même chambre (PECVD), permettant d'éviter de casser le vide, de contaminer le substrat par des polluants extérieurs, d'augmenter la rapidité du procédé de fabrication et de réduire les coûts de fabrication.

Cette étape de nettoyage a') par voie sèche est réalisée pendant une durée comprise entre 60 s et 900 s. La puissance du plasma est comprise entre 1 W et 30 W, correspondant à une densité de puissance comprise entre 10 mW/cm² et 300 mW/cm². La pression du gaz fluoré est comprise entre 1,33 Pa et 26,66 Pa.

Cette étape a') entraîne la fixation ou l'adsorption d'éléments fluorés sur la surface du substrat de silicium, provocant des défauts de surface, en particulier des liaisons Si brisées.

Ces éléments fluorés sont ensuite éliminés par l'opération d'exposition de la surface du substrat de silicium comprenant des éléments fluorés à un plasma radiofréquence d'hydrogène.

Cette opération d'exposition de la surface du substrat de silicium comprenant des éléments fluorés à un plasma radiofréquence d'hydrogène est réalisée pendant une durée comprise entre 5 s et 120 s, et avec une puissance de plasma comprise entre 1 W et 30 W (densité de puissance comprise entre 10 mW/cm² et 30 mW/cm²). La pression d'hydrogène est comprise entre 1,33 Pa et 133,32 Pa. Cette opération d'exposition à un plasma radiofréquence d'hydrogène est facultative.

L'invention fournit un procédé de fabrication de films minces de silicium cristallin plus simple, moins onéreux et permettant d'obtenir des films de silicium cristallin ayant une épaisseur comprise entre 0, 1 µm et 5 pm et de grande cristallinité.

## Revendications

1. Procédé de fabrication d'un film multicouche (2') comprenant au moins une couche mince de silicium cristallin (2), à partir d'un substrat (S) ayant une structure cristalline et comprenant une surface préalablement nettoyée,
comprenant les étapes suivantes :
a) exposition de ladite surface nettoyée à un plasma radiofréquence généré dans un mélange gazeux de SiF4_{,} d'hydrogène et d'argon, la densité de puissance du plasma radiofréquence étant comprise entre 100 mW/cm² et 600 mW/cm², la pression du mélange gazeux étant comprise entre 200 Pa et 400 Pa, la température du substrat (S) étant comprise entre 150°C et 300°C, le flux de SiF₄ étant compris entre 1 et 10 cm³/min, le flux d'hydrogène étant compris entre 1 et 60 cm³/min et le flux d'argon étant compris entre 1 et 80 cm³/min, afin de former sur ladite surface nettoyée, une couche mince de silicium cristallin (2) comportant plusieurs sous-couches (19, 20, 21) dont une sous couche d'interface (19) en contact avec le substrat (S) et comprenant des microcavités,
b) dépôt d'au moins une couche de matériau sur ladite couche mince de silicium cristallin (2) pour former, avec ladite couche mince de silicium cristallin (2), un film multicouche (2'), ledit film multicouche comprenant au moins une couche mécaniquement résistante (3) qui permet au film multicouche (2') d'avoir une résistance suffisante pour permettre le décollement dudit film multicouche (2') dudit substrat (5) sans endommager la couche ultra mince de silicium cristallin (2),
c) recuit du substrat (S) recouvert dudit film multicouche (2'), à une température supérieure à 400°C, permettant la séparation dudit film multicouche (2') du substrat (S).

2. Procédé de fabrication d'un film multicouche (2') selon la revendication 1, **caractérisé en ce que**, lors de l'étape a), la densité de puissance du plasma radiofréquence est de 500 mW/cm², la pression du mélange gazeux est de 293 Pa, et la température du substrat (S) est de 200°C.

3. Procédé de fabrication d'un film multicouche (2') selon l'une quelconque des revendications 1 ou 2, **caractérisé en ce que**, lors de l'étape a), le débit gazeux de SiF₄ est de 3 cm³/min, le débit gazeux d'hydrogène est de 5 cm³/min, et le débit gazeux d'argon est de 80 cm³/min.

4. Procédé de fabrication d'un film multicouche (2') selon l'une quelconque des revendications 1 à 3, **caractérisé en ce que** la couche mécaniquement résistante (3) est une couche de chrome déposée sur une des couches du film multicouche (2') par une méthode d'évaporation sous vide.

5. Procédé de fabrication d'un film multicouche (2') selon la revendication 4, **caractérisé en ce que**, lors de l'étape c), le substrat (S) recouvert dudit film multicouche (2') est chauffé jusqu'à 800°C.

6. Procédé de fabrication d'un film multicouche (2') selon l'une quelconque des revendications 1 à 5, **caractérisé en ce que**, la surface du substrat étant initialement recouverte d'une couche d'oxyde de silicium, le procédé de fabrication comprend, avant l'étape a), une étape a') de nettoyage de la surface du substrat initialement recouverte d'oxyde de silicium.

7. Procédé de fabrication d'un film multicouche (2') selon la revendication 6, **caractérisé en ce que** ladite étape a') comprend une opération d'exposition de ladite surface à un plasma radiofréquence généré à partir d'un gaz fluoré, produisant le décapage de la couche d'oxyde de silicium, et une opération d'exposition de ladite surface à un plasma radiofréquence d'hydrogène.

8. Procédé de fabrication d'un film multicouche (2') selon la revendication 7, **caractérisé en ce que** les étapes a') et a) sont réalisées dans une même chambre de réaction d'un réacteur de dépôt chimique en phase vapeur assisté par plasma.

9. Procédé de fabrication d'un film multicouche (2') selon l'une quelconque des revendications 1 à 8, **caractérisé en ce que** l'étape b) comprend une opération de dépôt d'une couche de passivation avant le dépôt de la couche mécaniquement résistante (3).

10. Procédé de fabrication d'un film multicouche (2') selon l'une quelconque des revendications 1 à 9, **caractérisé en ce que** lors de l'étape b), une première couche de matériau dopé P ou N est déposée sur ladite couche mince de silicium cristallin (2), ladite première couche de matériau dopé P ou N étant recouverte d'une deuxième couche de matériau dopé N ou P afin d'obtenir une jonction P-N ou N-P.

## Patentansprüche

1. Verfahren zur Herstellung eines mehrschichtigen Films (2') mit mindestens einer dünnen Schicht aus kristallinem Silizium (2) ausgehend von einem Substrat (S), das eine kristalline Struktur aufweist und eine vorhergehend gereinigte Fläche umfasst,
das die folgenden Schritte umfasst:
a) Aussetzen der gereinigten Fläche gegenüber einem Hochfrequenzplasma, das in einem Gasgemisch aus SiF₄, Wasserstoff und Argon erzeugt wird, wobei die Leistungsdichte des Hochfrequenzplasmas zwischen 100 mW/cm² und 600 mW/cm² enthalten ist, wobei der Druck des Gasgemisches zwischen 200 Pa und 400 Pa enthalten ist, wobei die Temperatur des Substrats (S) zwischen 150 °C und 300 °C enthalten ist, wobei der SiF₄-Strom zwischen 1 und 10 cm³/min enthalten ist, wobei der Wasserstoffstrom zwischen 1 und 60 cm³/min enthalten ist und der Argonstrom zwischen 1 und 80 cm³/min enthalten ist, um auf der gereinigten Fläche eine dünne Schicht aus kristallinem Silizium (2) zu bilden, die mehrere Unterschichten (19, 20, 21) umfasst, darunter eine Grenzflöchenunterschicht (19), die mit dem Substrat (S) in Berührung ist und Mikrohohlräume umfasst,
b) Abscheiden von mindestens einer Materialschicht auf der dünnen Schicht aus kristallinem Silizium (2), um mit der dünnen Schicht aus kristallinem Silizium (2) einen mehrschichtigen Film (2') zu bilden, wobei der mehrschichtige Film mindestens eine mechanisch feste Schicht (3) umfasst, die es dem mehrschichtigen Film (2') ermöglicht, eine Festigkeit aufzuweisen, die ausreicht, um die Ablösung des mehrschichtigen Films (2') des Substrats (S) ohne Beschädigung der ultradünnen Schicht aus kristallinem Silizium (2) zu ermöglichen,
c) Glühen des mit dem mehrschichtigen Film (2') bedeckten Substrats (S) bei einer Temperatur von über 400 °C, wodurch die Trennung des mehrschichtigen Films (2') von dem Substrat (S) ermöglicht wird.

2. Verfahren zur Herstellung eines mehrschichtigen Films (2') nach Anspruch 1, **dadurch gekennzeichnet, dass** während des Schritts a) die Leistungsdichte des Hochfrequenzplasmas 500 mW/cm² beträgt, der Druck des Gasgemisches 293 Pa beträgt und die Temperatur des Substrats (S) 200°C beträgt.

3. Verfahren zur Herstellung eines mehrschichtigen Films (2') nach einem der Ansprüche 1 oder 2, **dadurch gekennzeichnet, dass** beim Schritt a) der SiF₄-Gasdurchsatz 3 cm³/mm beträgt, der Wasserstoffgasdurchsatz 5 cm³/mm beträgt und der Argongasdurchsatz 80 cm³/mm beträgt.

4. Verfahren zur Herstellung eines mehrschichtigen Films (2') nach einem der Ansprüche 1 bis 3, **dadurch gekennzeichnet, dass** die mechanisch feste Schicht (3) eine Chromschicht ist, die auf einer der Schichten des mehrschichtigen Films (2') durch ein Vakuumverdampfungsverfahren abgeschieden wird.

5. Verfahren zur Herstellung eines mehrschichtigen Films (2') nach Anspruch 4, **dadurch gekennzeichnet, dass** beim Schritt c) das durch den mehrschichtigen Film (2') bedeckte Substrat (S) bis auf 800 °C erhitzt wird.

6. Verfahren zur Herstellung eines mehrschichtigen Films (2') nach einem der Ansprüche 1 bis 5, **dadurch gekennzeichnet, dass**, da die Fläche des Substrats anfangs durch eine Siliziumoxidschicht bedeckt ist, das Herstellungsverfahren vor dem Schritt a) einen Schritt a') der Reinigung der Fläche des anfangs mit Siliziumoxid bedeckten Substrats umfasst.

7. Verfahren zur Herstellung eines mehrschichtigen Films (2') nach Anspruch 6, **dadurch gekennzeichnet, dass** der Schritt a') einen Arbeitsvorgang des Aussetzens der Fläche gegenüber einem Hochfrequenzplasma, das ausgehend von einem fluorierten Gas erzeugt wird, das das Abbeizen der Siliziumoxidschicht bewirkt, und einen Arbeitsvorgang des Aussetzens der Fische gegenüber einem Hochfrequenz-Wasserstoffplasma umfasst.

8. Verfahren zur Herstellung eines mehrschichtigen Films (2') nach Anspruch 7, **dadurch gekennzeichnet, dass** die Schritte a') und a) in einer selben Reaktionskammer eines Reaktors für plasmagestützte chemische Gasphasenabscheidung ausgeführt werden.

9. Verfahren zur Herstellung eines mehrschichtigen Films (2') nach einem der Ansprüche 1 bis 8, **dadurch gekennzeichnet, dass** der Schritt b) einen Arbeitsvorgang des Abscheidens einer Passivierungsschicht vor dem Abscheiden der mechanisch festen Schicht (3) umfasst.

10. Verfahren zur Herstellung eines mehrschichtigen Films (2') nach einem der Ansprüche 1 bis 9, **dadurch gekennzeichnet, dass** beim Schritt b) eine erste Schicht aus p- oder n-dotiertem Material auf der dünnen Schicht aus kristallinem Silizium (2) abgeschieden wird, wobei die erste Schicht aus p- oder n-dotiertem Material mit einer zweiten Schicht aus p- oder n-dotiertem Material bedeckt ist, um einen p-n- oder n-p-Übergang zu erhalten.

## Claims

1. A method of fabricating a multilayer film (2') comprising at least one thin layer (2) of crystalline silicon, the film being fabricated from a substrate (S) having a crystalline structure and comprising a previously-cleaned surface,
comprising the following steps:
a) exposing said cleaned surface to a radiofrequency plasma generated in a gaseous mixture of SiF₄, hydrogen, and argon, the power density of the radiofrequency plasma lying in the range 100 mW/cm² to 600 mW/cm², the pressure of the gaseous mixture in the range 200 Pa to 400 Pa, the temperature of the substrate (S) lying in the range 150°C to 300°C, the flow rate of SiF₄ lying in the range 1 cm³/min to 10 cm³/min, the flow rate of hydrogen lying in the range 1 cm³/min to 60 cm³/min, the flow rate of argon lying in the range 1 cm³/min to 80 cm³/min, so as to form on said cleaned surface a thin layer of crystalline silicon (2) comprising a plurality of sub-layers (19, 20, 21) including an interface sub-layer (19) in contact with the substrate (S) and containing microcavities;
b) depositing at least one layer of material on said thin layer of crystalline silicon (2) so as to co-operate with said thin layer of crystalline silicon (2) to form a multilayer film (2'), said multilayer film including at least one mechanically strong layer (3) than enables the multilayer film (2') to have sufficient strength to enable said multilayer film (2') to be separated from said substrate without damaging the thin layer of crystalline silicon (2); and
c) annealing the substrate (S) covered with said multilayer film (2') at a temperature higher than 400°C, thereby enabling said multilayer film (2') to be separated from the substrate (S).

2. A method of fabricating a multilayer film (2') according to claim 1, the method being **characterized in that** during step a), the power density of the radiofrequency plasma is 500 mW/cm², the pressure of the gaseous mixture is 293 Pa, and the temperature of the substrate (S) is 200°C.

3. A method of fabricating a multilayer film (2') according to claim 1 or claim 2, **characterized in that** during step a), the gaseous flow rate of SiF₄ is 3 cm³/min, the gaseous flow rate of hydrogen is 5 cm³/min, and the gaseous flow rate of argon is 80 cm³/min.

4. A method of fabricating a multilayer film (2') according to any one of claims 1 to 3, **characterized in that** the mechanically strong layer (3) is a layer of chromium deposited on one of the layers of the multilayer film (2') by a vacuum evaporation method.

5. A method of fabricating a multilayer film (2') according to claim 4, **characterized in that** during step c) the substrate (S) covered with said multilayer film (2') is heated up to 800°C.

6. A method of fabricating a multilayer film (2') according to any one of claims 1 to 5, **characterized in that** the surface of the substrate is initially covered with a layer of silicon oxide and the fabrication method includes, prior to step a), a step a') of cleaning the surface of the substrate that is initially covered with silicon oxide.

7. A method of fabricating a multilayer film (2') according to claim 6, **characterized in that** said step a') comprises an operation of exposing said surface to a radiofrequency plasma generated from a fluorine-containing gas, thereby etching the layer of silicon oxide, and an operation of exposing said surface to a radiofrequency plasma of hydrogen.

8. A method of fabricating a multilayer film (2') according to claim 7, **characterized in that** the steps a') and a) are performed in the same reaction chamber of a PECVD reactor.

9. A method of fabricating a multilayer film (2') according to any one of claims 1 to 8, **characterized in that** step b) includes an operation of depositing a passivation layer prior to depositing the mechanically strong layer (3).

10. A method of fabricating a multilayer film (2') according to any one of claims 1 to 9, **characterized in that** during step b), a first layer of P- or N-doped material is deposited on said thin crystalline silicon layer (2), said first layer of P- or N-doped material being covered with a second layer of N- or P-doped material in order to obtain a P-N or an N-P junction.
